# EUROPEAN PATENT APPLICATION

(11) **EP 2 383 801 A1**
(43) Date of publication of application: **02.11.2011**
(21) Application number: 09839251.7
(22) Date of filing: 11.11.2009
(51) Int. Cl.: H01L 33/00

(54) **SEMICONDUCTOR LIGHT-EMITTING ELEMENT AND METHOD FOR MANUFACTURING SEMICONDUCTOR LIGHT-EMITTING ELEMENT**

(30) Priority: 28.01.2009 JP 2009016846
(71) Applicant: Sumitomo Electric Industries, Ltd., Chuo-ku Osaka-shi Osaka 541-0041 (JP)
(72) Inventor: KITABAYASHI, Hiroyuki, Osaka-shi Osaka 554-0024 (JP); MATSUBARA, Hideki, Osaka-shi Osaka 554-0024 (JP)
(74) Representative: Grünecker, Kinkeldey, Stockmair & Schwanhäusser
(86) International application number: PCT/JP2009/069152
(87) International publication number: WO 2010/087062

(57) **Abstract**

A semiconductor light-emitting device 100 includes a semiconductor layer 2 including an active layer, a supporting substrate 11 for supporting the semiconductor layer 2, and an attachment layer 15 for bonding a main surface of the semiconductor layer 2 onto a main surface of the supporting substrate 11. A two-dimensional diffraction grating is formed in a bonding interface region between the attachment layer and at least one of the main surface of the semiconductor layer 2, the main surface opposing the attachment layer 15, and the main surface of the supporting substrate 11, the main surface opposing the attachment layer 15, the two-dimensional diffraction grating including at least two types of materials having different refractive indices and being arranged periodically.

## Description

### TECHNICAL FIELD

The present invention relates to a semiconductor light-emitting device and a method for manufacturing a semiconductor light-emitting device. More particularly, the present invention relates to a semiconductor light-emitting device that can improve the efficiency at which the emitted light is output and a method for manufacturing such a semiconductor light-emitting device.

### BACKGROUND ART

A semiconductor light-emitting device retrieves as light the energy released by recombination of holes, which are provided by a p-type semiconductor layer included in a semiconductor layer, and electrons, which are provided by an n-type semiconductor layer, in an active layer. Such semiconductor light-emitting devices (LEDs) are used in a wide range of usages including optical displays and signals. Various efforts have been made to improve the efficiency of outputting light emitted by the semiconductor light-emitting device and to increase the intensity ofthe output light.

For example, Patent Literature 1 and Non-Patent Literature 1 below disclose a method for manufacturing a semiconductor light-emitting device in which a semiconductor layer that releases light is bonded onto an electrically conductive supporting substrate by using an adhesive layer composed of a metal having a high reflectivity to that light. Since the light emitted by the semiconductor device is reflected by the adhesive layer composed of the metal in a particular direction at a high reflectivity, the light output intensity can be increased.

Patent Literature 2 and Non-Patent Literature 2 below disclose a semiconductor light-emitting device in which a periodical structure of a two-dimensional diffraction grating is formed on the surface of a semiconductor layer. According to the semiconductor light-emitting device, light emitted inside the semiconductor layer is diffracted with the two-dimensional diffraction grating and a high percentage of light is released in a particular direction; hence, the output intensity can be increased.

### Citation List

### PATENT LITERATURE

PTL 1: Japanese Unexamined Patent Application Publication No. 2005-175462
PTL 2: Japanese Unexamined Patent Application Publication No. 2005-129939 Non Patent Literature

NPL 1: R. H. Horng, S. H. Huang and D. S. Wuu, C. Y. Chiu. "AlGaInP/mirror/Si light-emitting diodes with vertical electrodes by wafer bonding" Applied Physics Letters, USA, June 9, 2003, vol. 82, No. 23, pp. 4011-4013
NPL 2: Hiroyuki Ichikawa and Toshihiko Baba, "Efficiency enhancement in a light-emitting diode with a two-dimensional surface grating photonic crystal", Applied Physics Letters, USA, January 26, 2004, vol. 84, No. 4, pp. 457-459

### SUMMARY OF INVENTION

### TECHNICAL PROBLEM

However, for example, as shown in Fig. 8 of Patent Literature 2, the periodical structure of the two-dimensional diffraction grating is formed on the surface of the semiconductor layer of the semiconductor light-emitting device. In this case, since electrodes are formed on the surface of the semiconductor layer, the area of the region where the two-dimensional diffraction grating can be placed decreases by the placement of the electrodes. The two-dimensional diffraction grating has a function of releasing the light, which has been emitted by the semiconductor layer, in a particular direction. Thus, if the area of the region where the periodical structure of the two-dimensional diffraction grating can be placed is limited, the efficiency at which the light emitted from the semiconductor light-emitting device is output or the output intensity may decrease.

The present invention addresses the challenges described above. An object of the present invention is to provide a semiconductor light-emitting device having an improved efficiency of outputting emitted light and a method for manufacturing the semiconductor light-emitting device.

### SOLUTION TO PROBLEM

A semiconductor light-emitting device according to the present invention includes a semiconductor layer including active layer, a supporting substrate for supporting the semiconductor layer, and an attachment layer that bonds a main surface of the semiconductor layer onto a main surface of the supporting substrate. A two-dimensional diffraction grating is formed in a bonding interface region between the attachment layer and at least one of the main surface of the semiconductor layer, the main surface opposing the attachment layer, and the main surface of the supporting substrate, the main surface opposing the attachment layer. In the two-dimensional diffraction grating, at least two types of materials having different refractive indices are periodically arranged.

According to the semiconductor light-emitting device of the present invention, the two-dimensional diffraction grating is not formed on the surface of a stacking structure that includes the semiconductor layer, the supporting substrate, and the attachment layer that make up the semiconductor light-emitting device but in a bonding interface region. Here, the term "bonding interface region" refers to a region at a particular depth from a main surface bonded. The term "main surface" refers to a main surface that has the largest area among surfaces. When the periodical structure of the two-dimensional diffraction grating is formed in the bonding interface region of the stacking structure, the periodical structure of the two-dimensional diffraction grating is not formed on the surface of the stacking structure. Accordingly, formation of electrodes on the surface of the stacking structure does not affect the area occupied by the two-dimensional diffraction grating in the direction along the main surface of the stacking structure. Thus, the efficiency at which light emitted by the semiconductor layer is diffracted by the two-dimensional diffraction grating and output in a particular direction can be improved.

When a process of increasing the surface roughness of the surface of the stacking structure is performed, i.e., when a process of roughening the surface of the stacking structure is performed, a phenomenon that the light output from the surface of the stacking structure is reflected by total reflection at that surface can be suppressed. As a result, the intensity of light output from the surface of the stacking structure can be increased. However, if a periodical structure of the two-dimensional diffraction grating is placed on the surface of the stacking structure, it is difficult to conduct a surface roughening process on the region where the periodical structure of the two-dimensional diffraction grating is placed. In contrast, when the periodical structure of the two-dimensional diffraction grating is not placed on the surface of the stacking structure as in the case of the semiconductor light-emitting device of the present invention, the surface roughening process described above can be conducted on the surface of the stacking structure in the region excluding the region where the electrodes are formed. Thus, the efficiency at which the semiconductor light-emitting device outputs light can be further improved by conducting this process.

With regard to the semiconductor light-emitting device of the present invention, the materials forming the two-dimensional diffraction grating preferably contain a semiconductor material constituting the semiconductor layer and a filling material that fills a plurality of concave portions periodically formed on the surface of the semiconductor layer. The semiconductor material and the filling material are periodically arranged on the main surface (bonding interface region) of the semiconductor layer, the main surface opposing the attachment layer. The light incident on the two-dimensional diffraction grating is diffracted due to the period of arrangement and the difference in refractive index between the semiconductor material and the filling material and can thus be output in a desired direction.

The filling material is preferably a transparent material that makes an ohmic contact with the semiconductor material, transmits light emitted by the active layer, and is electrically conductive. Note that "transmits light" means that incident light is transmitted at a transmittance of 80% or more. The term "transparent" means that when light having a particular wavelength is incident on an object, that object is "transparent" with respect to the incident light having the particular wavelength if the incident light is transmitted at a transmittance of 80% or more. The term "electrically conductive" means that the electric conductivity is 10 siemens/cm or more. The transparent material is preferably composed of a material containing at least one selected from the group consisting of an indium oxide-tin oxide mixture, zinc oxide containing aluminum atoms, tin oxide containing fluorine atoms, zinc oxide, zinc selenide, and gallium oxide. Examples of the light emitted by the active layer include infrared and visible light. The wavelength of the infrared is about 0.7 µm to 1000 µm, and the wavelength of the visible light is about 0.36 µm to 0.7 µm. That is, when a material that transmits light having these wavelengths at a transmittance of 80% or more and that has an electric conductivity of 10 siemens/cm or more is used as the filling material, the electric conductivity as the semiconductor light-emitting device and the function of emitting the emitted light as the two-dimensional diffraction grating can be achieved. Specifically, the above-described materials are preferably used as the filling material (transparent material).

The filling material of the semiconductor light-emitting device of the present invention may be a dielectric film. In particular, the filling material is preferably composed of a material containing at least one selected from the group consisting of silicon oxide, magnesium fluoride, calcium fluoride, barium fluoride, and lithium fluoride.
When an electrically conductive transparent material is to be used as the filling material as described above, the choice of the material to be used as the filling material must be made from a very limited range of materials. According to a two-dimensional diffraction grating including dielectric films and a semiconductor material that are formed on the main surface of the semiconductor layer and periodically arranged, light emitted by the active layer can be diffracted under desired conditions and can be output at a high efficiency under desired conditions due to the difference in refractive index between the dielectric material and the semiconductor material. Thus, the range of choice of material for use as the filling material can be widened by use of a dielectric material as the filling material.

Regarding the semiconductor light-emitting device of the present invention, a region sandwiched between the two-dimensional diffraction grating and the supporting substrate preferably includes a reflective film composed of a metal material that reflects light emitted by the active layer. In this manner, a high percentage of light emitted by the semiconductor light-emitting device can be emanated in a particular direction by reflection. Thus, the intensity of outputting light emitted by the active layer can be enhanced. In particular, the reflective film is preferably composed of a material containing at least one selected from the group consisting of aluminum, gold, platinum, silver, copper, and chromium. In this manner, a higher percentage of light can be reflected and the intensity at which the light is output in a particular direction can be increased.

Regarding the semiconductor light-emitting device of the present invention, air may be used as the filling material. A two-dimensional diffraction grating that is formed on the main surface of the semiconductor layer and includes air and a semiconductor material periodically arranged can also allow the light emitted by the active layer to be diffracted under desired conditions and to be output at a high efficiency under desired conditions due to the difference in refractive index between air and the semiconductor material.

Regarding the semiconductor light-emitting device of the present invention described above, the supporting substrate is preferably an electrically conductive supporting substrate. In particular, the supporting substrate is preferably composed of a material containing at least one selected from the group consisting of silicon, gallium arsenide, and silicon carbide. When the electrically conductive supporting substrate described above is used as the supporting substrate and electrodes are respectively formed on surfaces of a pair of opposing main surfaces of the stacking structure, electric power can be smoothly supplied to the semiconductor light-emitting device by applying a voltage between the electrodes.

Regarding the semiconductor light-emitting device of the present invention, the filling material may be a transparent adhesive material that has adhesiveness to the semiconductor layer and the supporting substrate and that transmits light emitted by the active layer. In particular, the transparent adhesive material is preferably composed of a material that contains at least one selected from the group consisting of polyimide (PI), epoxy, silicone, and perfluorocyclobutane (PFCB). When the filling material is a transparent adhesive material that is transparent and has adhesiveness, the transparent adhesive material is used not only as the material for manufacturing the two-dimensional diffraction grating but also as the material for bonding the semiconductor layer onto the supporting substrate. As a result, light emitted from the active layer can be transmitted and enters the supporting substrate side.

In bonding the semiconductor layer onto the supporting substrate by using the transparent adhesive material as described above, a transparent material that transmits 80% or more of light having a wavelength emitted from the active layer may be used in the supporting substrate. In this manner, the light emitted by the semiconductor layer propagates into the supporting substrate through the transparent adhesive material, is reflected by a silver paste applied to fix one of the main surfaces of the supporting substrate onto a lead frame, passes through the active layer again, and is output from the surface of the stacking structure. The transparent supporting substrate is preferably composed of a material that contains at least one selected from the group consisting of sapphire, gallium phosphide, quartz, and spinel.

Regarding the semiconductor light-emitting device of the present invention, the composition of the active layer included in the semiconductor layer is preferably at least one selected from the group consisting of AlₓGa_{y}In_{(1-x-y)}As (where 0 ≤ x < 1, 0 < y ≤ 1, and 0 < x + y ≤ 1), AlₓGa_{y}In_{(1-x-y)}P (where 0 < x < 1, 0 < y < 1, and 0 < x + y < 1), AlₓIn_{y}Ga_{(1-x-y)}N (where 0 ≤ x < 1, 0 < y < 1, and 0 < x + y < 1), and InₓGa₍₁₋ₓ₎AS_{y}P_{(1-y)} (where 0 < x < I and 0 < y < 1). For example, when the composition of the active layer is AlₓGa_{y}In_{(1-x-y)}As or InₓGa₍₁₋ₓ₎AS_{y}P_{(1-y)}, infrared can be emitted. When the composition of the active layer is AlₓGa_{y}In_{(1-x-y)}P, red visible light can be emitted. When the composition ofthe active layer is AlₓIn_{y}Ga_{(1-x-y)}N, visible light ranging from violet to blue and green can be emitted.

Regarding the semiconductor light-emitting device of the present invention, the two-dimensional diffraction grating may be made of two types of materials having different refractive indices and being arranged into a square lattice or a triangular lattice. For example, when the two-dimensional diffraction grating is placed on a main surface of the semiconductor layer, the semiconductor material and the filling material may be arranged to form a square lattice or a triangular lattice. When the wavelength of the light emitted by the active layer, the lattice constant indicating the period of the square or triangular lattice, the depth (thickness) of the concave portions where the filling material is formed in a direction perpendicular to the main surface of the semiconductor layer, and the refractive indices of the semiconductor material and the filling material satisfy particular conditions, the two-dimensional diffraction grating can emanate light, which has been emitted by the active layer, in a desired direction at a desired intensity.

Regarding the conditions that the square or triangular lattice of the two-dimensional diffraction grating should satisfy, the relationship, 0.2λ ≤ a ≤ 10λ is preferably established where λ represents the wavelength of the light emitted by the active layer and a represents the lattice constant of the square or triangular lattice on the main surface of the semiconductor layer.

Furthermore, the relationship, 0.1λ ≤ d ≤ 5λ, is preferably established where d represents the thickness of the two-dimensional diffraction grating in a direction perpendicular to the main surface of the semiconductor layer.

The semiconductor light-emitting device of the present invention can highly efficiently output light emitted by the active layer when the wavelength λ of the light emitted by the active layer is 400 nm to 2 µm, the lattice constant a is 80 nm to 20 µm, and the thickness d is 40 nm to 10 µm.

A method for manufacturing the semiconductor light-emitting device of the present invention described above preferably includes a step of forming a semiconductor layer on a surface of a semiconductor substrate, a step of preparing a supporting substrate for supporting the semiconductor layer, a step of forming a two-dimensional diffraction grating on at least one of a surface of the semiconductor layer and a surface of the supporting substrate, a step of bonding the surface of the semiconductor layer onto the surface of the supporting substrate, and a step of removing the semiconductor substrate. The semiconductor light-emitting device of the present invention made by the method having the aforementioned steps can improve the efficiency of outputting emitted light and increase the intensity of the output light.

### Advantageous Effects of Invention

According to the present invention, a semiconductor light-emitting device that can improve the efficiency of outputting emitted light and a method for manufacturing the semiconductor light-emitting device can be provided.

### BRIEF DESCRIPTION OF DRAWINGS

[Figure 1] Figure 1 is a schematic cross-sectional view showing a stacking structure of a semiconductor light-emitting device according to embodiment 1.
[Figure 2] Figure 2 is a flowchart showing a method for manufacturing a semiconductor light-emitting device according to the embodiment.
[Figure 3] Figure 3 is a schematic cross-sectional view showing a substrate on which a semiconductor layer is formed in step (S10).
[Figure 4] Figure 4 is a schematic cross-sectional view showing a state in which the semiconductor layer is formed on a main surface of the substrate in step (S 10).
[Figure 5] Figure 5 is a schematic cross-sectional view showing a structure of concave portions constituting a two-dimensional diffraction grating.
[Figure 6] Figure 6 is a schematic perspective view of a two-dimensional diffraction grating (concave portions) formed into a triangular lattice.
[Figure 7] Figure 7 is a schematic top view of a stacking surface 2a on which a two-dimensional diffraction grating (concave portions) are formed into a triangular lattice.
[Figure 8] Figure 8 is a schematic perspective view of a two-dimensional diffraction grating (concave portions) formed into a square lattice.
[Figure 9] Figure 9 is a schematic top view of a stacking surface 2a on which a two-dimensional diffraction grating (concave portions) are formed into a square lattice.
[Figure 10] Figure 10 is a schematic cross-sectional view of a structure in which concave portions 3 are filled with a filling material.
[Figure 11] Figure 11 is a schematic cross-sectional view showing a structure in which a semiconductor layer 2 is bonded onto a supporting substrate 11 in step (S40).
[Figure 12] Figure 12 is a schematic cross-sectional view of a semiconductor light-emitting device 200 prepared by subjecting an emission surface 2b of a semiconductor light-emitting device 100 to a surface roughening process.
[Figure 13] Figure 13 is a schematic cross-sectional view showing a stacking structure of a semiconductor light-emitting device according to embodiment 2.
[Figure 14] Figure 14 is a schematic cross-sectional view showing a structure in which a reflective film 16 is formed to conduct attaching in a process of forming a semiconductor light-emitting device 300.
[Figure 15] Figure 15 is a schematic cross-sectional view showing a stacking structure of a semiconductor light-emitting device according to embodiment 3.
[Figure 16] Figure 16 is a schematic cross-sectional view showing a structure in which a transparent electrically conductive film 5 is formed in a process of forming a semiconductor light-emitting device 400.
[Figure 17] Figure 17 is a schematic cross-sectional view showing a structure in which a semiconductor layer 2 is attached onto a supporting substrate 11 in the process of forming the semiconductor light-emitting device 400.
[Figure 18] Figure 18 is a schematic cross-sectional view showing a stacking structure of a semiconductor light-emitting device according to embodiment 4.
[Figure 19] Figure 19 is a schematic cross-sectional view showing a structure in which a semiconductor layer 2 is attached onto a supporting substrate 11 in a process of forming a semiconductor light-emitting device 500.
[Figure 20] Figure 20 is a schematic cross-sectional view showing a stacking structure of a semiconductor light-emitting device according to embodiment 5.
[Figure 21] Figure 21 is a schematic cross-sectional view showing a structure in which a semiconductor layer 2 is attached onto a supporting substrate 11 in step (S40) of a method for manufacturing a semiconductor light-emitting device 600.
[Figure 22] Figure 22 is a schematic cross-sectional view showing a structure of a semiconductor light-emitting device according to embodiment 6.
[Figure 23] Figure 23 is a schematic cross-sectional view showing a structure in which concave portions 3 are filled with a filling material in the embodiment 6.
[Figure 24] Figure 24 is a schematic cross-sectional view showing a structure in which a semiconductor layer 2 is attached onto a supporting substrate 11 in step (S40) according to the embodiment 6.
[Figure 25] Figure 25 is a schematic cross-sectional view showing a stacking structure of a semiconductor light-emitting device of embodiment 7.
[Figure 26] Figure 26 is a schematic cross-sectional view showing a structure in which a reflective film 16 is formed to conduct attaching in a process of forming a semiconductor light-emitting device 800.
[Figure 27] Figure 27 is a schematic cross-sectional view showing a stacking structure of a semiconductor light-emitting device according to embodiment 8.
[Figure 28] Figure 28 is a schematic cross-sectional view showing a structure in which a semiconductor layer 2 is attached onto a transparent supporting substrate 12 in a process of forming a semiconductor light-emitting device 900.
[Figure 29] Figure 29 is a schematic cross-sectional view showing a stacking structure of a semiconductor light-emitting device according to embodiment 9.
[Figure 30] Figure 30 is a schematic cross-sectional view showing a structure in which a semiconductor layer 2 is attached onto a transparent supporting substrate 12 in a process of forming a semiconductor light-emitting device 999.

### REFERENCE SIGNS LIST

- 1: substrate
- 2: semiconductor layer
- 2a: stacking surface
- 2b, 2c, 12b: emission surface
- 2d: p-type semiconductor layer surface
- 2e: n-type semiconductor layer surface
- 3: concave portion
- 4, 5: transparent electrically conductive film
- 6: air hole
- 7: dielectric film
- 8: transparent adhesive layer
- 11: supporting substrate
- 12: transparent supporting substrate
- 12b: main surface
- 15: attachment layer
- 16: reflective film
- 17: bonding layer
- 21: p-side electrode
- 22: n-side electrode
- 100, 200, 300, 400, 500, 600, 700, 800, 900, 999: semiconductor light-emitting device

### DESCRIPTION OF EMBODIMENTS

Embodiments of the present invention will now be described with reference to the drawings. In the embodiments, elements having the same functions are represented by the same reference symbols and descriptions therefor will not be repeated unless necessary.

### (Embodiment 1)

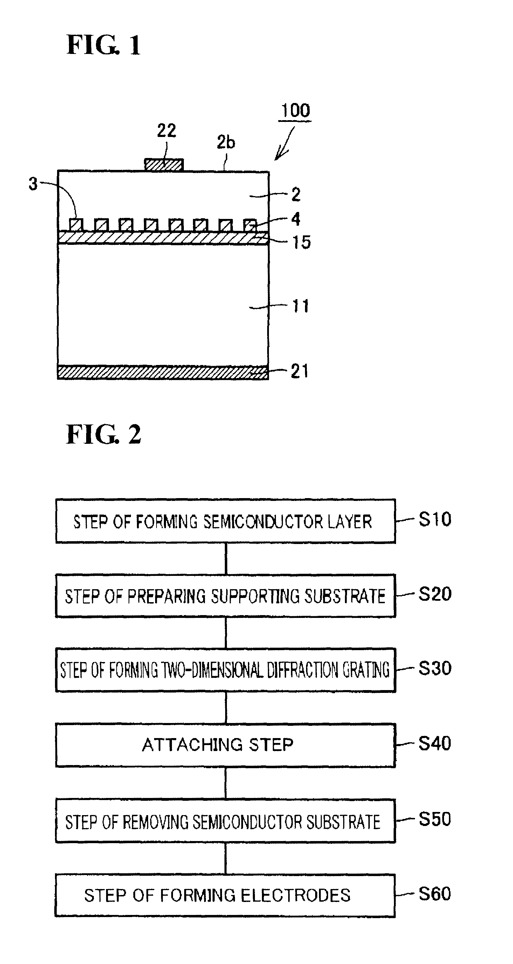

A semiconductor light-emitting device 100 shown in Fig. 1 has a stacking structure that includes a semiconductor layer 2 including an active layer, a supporting substrate 11 that supports the entire semiconductor light-emitting device 100, and an attachment layer 15 that bonds one of the main surfaces of the semiconductor layer 2 (the lower main surface of the semiconductor layer 2 shown in Fig. 1) onto one of the main surfaces of the supporting substrate 11 (the upper main surface of the supporting substrate 11 shown in Fig. 1). The lower main surface of the semiconductor layer 2 (the main surface opposing the attachment layer 15) has a two-dimensional diffraction grating in a bonding interface region with the attachment layer 15. A semiconductor material constituting the semiconductor layer 2 and transparent conductive films 4 filling concave portions 3 are periodically arranged to form a two-dimensional diffraction grating that extends in a direction along the main surface of the semiconductor layer 2. A p-side electrode 21 and an n-side electrode 22 are formed on main surfaces of the surfaces of the stacking structure.

The semiconductor layer 2 includes an n-type cladding layer, a p-type cladding layer, an active layer, an electron-blocking layer, a photonic crystal layer, and other associated components not shown in the drawings in addition to the two-dimensional diffraction grating in the bonding interface region. These layers are stacked as with the stacking structure of the semiconductor light-emitting device 100. The n-type cladding layer is a region that functions as an n-type semiconductor layer that supplies electrons. The p-type cladding layer is a region that functions as a p-type semiconductor layer that supplies holes. The n-type cladding layer and the p-type cladding layer are composed of, for example, a group III-V compound semiconductor, in particular, an AlGaAs- or AlGaInP-based compound semiconductor.

The active layer is a region where energy released by recombination of electrons and holes supplied by application of voltage to the semiconductor light-emitting device 100 is retrieved as light. The composition of the active layer differs depending on the wavelength of the light desired to be retrieved. For example, the composition of the active layer is preferably AlₓGa_{y}In_{(1-x-y)}As or InₓGa₍₁₋ₓ₎As_{y}P_{(1-y)} when emission of infrared is desired, preferably AlₓGa_{y}In_{(1-x-y)}P when emission of red visible light is desired, and preferably AlₓIn_{y}Ga_{(1-x-y)}N when emission of visible light ranging from violet to blue and green is desired. The electron-blocking layer is a layer disposed to suppress electrons that have been supplied to the active layer but remain not recombined with the holes in the active layer from leaking to the p-type cladding layer. Thus, when the electron-blocking layer is disposed, the efficiency of recombination of the electrons and holes in the active layer and emission can be increased.

The two-dimensional diffraction grating is formed by periodically arranging the filling material that fills periodically formed concave portions 3 having a particular depth from one of the main surfaces of the photonic crystal layer, and the semiconductor material constituting the semiconductor layer 2 (photonic crystal layer) in the bonding interface region in the direction along the main surface of the semiconductor layer 2. The transparent conductive films 4 are disposed as the filling material. Here, the term "depth" refers to a length in a vertical direction of Fig. 1 extending in a direction perpendicular to the main surface.

The transparent conductive films 4 functioning as the filling material are preferably a transparent material that makes an ohmic contact with the semiconductor material, transmits light emitted by the active layer, and is electrically conductive. In such a case, conduction can be established between the transparent conductive films 4 and the semiconductor material constituting the semiconductor layer; accordingly, the light emitted by the active layer can be introduced into the interiors of the transparent conductive films 4 so that the light can be diffracted by the two-dimensional diffraction grating and the diffracted light can be transmitted through the transparent conductive films 4.

The transparent conductive films 4 that serve as a material that is transparent to the infrared and visible light emitted by the active layer of the semiconductor light-emitting device 100 and that is electrically conductive are preferably composed of a material containing at least one selected from the group consisting of an indium oxide-tin oxide mixture, zinc oxide containing aluminum atoms, tin oxide containing fluorine atoms, zinc oxide, zinc selenide, and gallium oxide.

The supporting substrate 11 is preferably an electrically conductive supporting substrate. In this manner, when voltage is applied between the p-side electrode 21 and the n-side electrode 22, the entire semiconductor light-emitting device 100 including the supporting substrate 11 can be made conductive. As a result, electrical power can be smoothly supplied to the semiconductor light-emitting device 100. In particular, the supporting substrate 11 is preferably composed of a material containing at least one selected from the group consisting of silicon (Si), gallium arsenide (GaAs), and silicon carbide (SiC). In the semiconductor light-emitting device 100, for example, the supporting substrate 11 is a supporting substrate composed of p-type Si.

In order to support the entire semiconductor light-emitting device 100 including the semiconductor layer 2 with the supporting substrate 11, the main surface of the photonic crystal layer on which the two-dimensional diffraction grating is formed is bonded onto one of the main surfaces of the supporting substrate 11 with the attachment layer 15. A solder that can be melt-bonded at a relatively low temperature is preferred as the attachment layer 15. For example, AuSn or AuIn is preferably used. In the semiconductor light-emitting device 100, for example, the attachment layer 15 is AuSn. Since AuSn used in the attachment layer 15 has good electrical conductive property, the semiconductor layer 2 can be firmly bonded onto the supporting substrate 11 by placing such a attachment layer 15. Moreover, the conduction condition between the p-side electrode 21 and the n-side electrode 22 can be further improved.

As described above, in the semiconductor light-emitting device 100, the main surface of the photonic crystal layer on which the two-dimensional diffraction grating is formed is arranged to oppose the attachment layer 15. In other words, the two-dimensional diffraction grating is placed in a region at a particular depth from the surface of the stacking structure of the semiconductor light-emitting device 100. Accordingly, no two-dimensional diffraction grating is formed on an emission surface 2b, which is the main surface of the surface of the semiconductor layer 2. With this structure, no electrode is disposed on the main surface on which the two-dimensional diffraction grating is formed. Thus, the two-dimensional diffraction grating can be formed over the entire main surface. Therefore, a large region (over the entire main surface of the semiconductor layer 2) can be secured for formation of the two-dimensional diffraction grating. Thus, the two-dimensional diffraction grating achieves a greater effect of enhancing the efficiency of outputting light, which has been emitted by the active layer, in a desired direction.

When the semiconductor light-emitting device 100 is operated, light emitted from the active layer included in the semiconductor layer 2 travels toward the bonding interface region. When particular conditions are met between parameters such as the wavelength of the light, the period (lattice constant) of arranging the two-dimensional diffraction grating in which a semiconductor material and a filling material having different refractive indices are periodically arranged, the depth at which the two-dimensional diffraction grating lies in a direction perpendicular to the main surface, and the difference in refractive index between the materials, the light is diffracted by the two-dimensional diffraction grating and the intensity of the light output in a desired direction is enhanced thereby. When the two-dimensional diffraction grating is absent, light may be absorbed by an opaque supporting substrate or may not be output to the outside of the light-emitting device due to total reflection. However, since the two-dimensional diffraction grating is provided to the semiconductor light-emitting device 100, the light is diffracted by the two-dimensional diffraction grating, travels toward the n-side electrode 22, and is output at a high intensity and high efficiency from the emission surface 2b.

Unlike the semiconductor light-emitting device disclosed in Patent Literature 2 or Non-Patent Literature 2, the semiconductor light-emitting device 100 has a two-dimensional diffraction grating arranged as shown in Fig. 1 and thus concave portions of the two-dimensional diffraction grating are not formed on the emission surface 2b, i.e., the surface of the stacking structure of the semiconductor layer 2. Thus, the surface roughening process of the emission surface 2b, which has been difficult to conduct on the semiconductor light-emitting device disclosed in Patent Literature 2 or Non-Patent Literature 2, can be easily conducted on the semiconductor light-emitting device 100. The surface roughening process refers to a process of increasing the roughness of the surface. When the surface roughening process is conducted, it becomes possible to suppress a phenomenon of a decrease in output efficiency caused by the total reflection of light, which has been diffracted by the two-dimensional diffraction grating and is about to be released from the emission surface 2b at a high efficiency, at the emission surface 2b. Accordingly, increasing the surface roughness of the emission surface 2b can increase the efficiency of retrieving the light and the intensity of output. Note that any common method may be used as the surface roughening process. For example, the surface roughness of the emission surface 2b may be increased by wet etching using a particular etchant (e.g., diluted nitric acid).

Since p-type Si is used in the supporting substrate 11 as described above, the stacking structure of the semiconductor light-emitting device 100 preferably has an LED (diode) structure including a p-type semiconductor material disposed on the lower side in Fig. 1 and an n-type semiconductor material disposed on the upper side in Fig. 1. Accordingly, the semiconductor layer 2 of the semiconductor light-emitting device 100 preferably includes an n-type cladding layer on the upper side and a p-type cladding layer on the lower side with an active layer between the cladding layers. For the reasons described above, in the semiconductor light-emitting device 100 shown in Fig. 1, an electrode disposed on the upper side (semiconductor layer 2 side) is the n-side electrode 22, and an electrode disposed on the lower side (supporting substrate 11 side) is the p-side electrode 21.

A method for manufacturing the semiconductor light-emitting device 100 is described next. Referring to the flowchart in Fig. 2, a step (S10) of forming a semiconductor layer is first performed according to the method for manufacturing the semiconductor light-emitting device 100 shown in Fig. 1. More specifically, this step is a step of forming a semiconductor layer including an n-type cladding layer, a p-type cladding layer, an active layer, etc., on a main surface of a substrate, in particular, a semiconductor substrate.

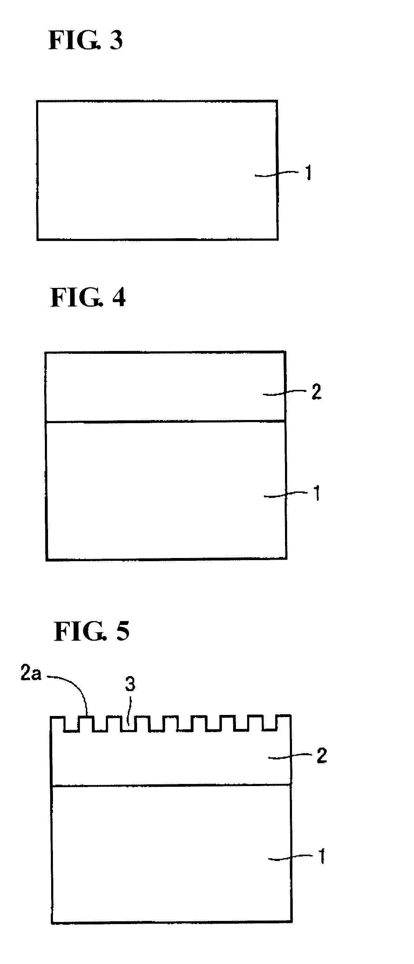

In forming the semiconductor light-emitting device 100, the material for a substrate 1 used as a semiconductor substrate for forming the semiconductor layer 2 shown in Fig. 3 is preferably n-type GaAs, but other substrates, such as an n-type GaN or InP substrate may be used. In the description below, the case in which an n-type GaAs is used as the substrate 1 is described.

As shown in Fig. 4, a semiconductor layer 2 which is a light-emitting region of the semiconductor light-emitting device 100 is formed on one of the main surfaces of the substrate 1 (the upper main surface in Fig. 3). The semiconductor layer 2 preferably has a stacking structure prepared by forming an n-type cladding layer, an active layer, an electron-blocking layer, a p-type cladding layer, and a layer that will form a photonic crystal layer in that order from the side near the substrate 1. The layer that will form the photonic crystal layer, and the electron-blocking layer are preferably composed of, for example, AlGaAs having a bandgap larger than that of the active layer. The layers constituting the stacking structure of the semiconductor layer 2 described above are preferably formed by metalorganic vapor phase epitaxy (MOVPE method) but may be formed by vapor phase epitaxy (VPE method) or hydride vapor phase epitaxy (H-VPE method).

Next, as shown in Fig. 2, a step (S20) of preparing a supporting substrate is performed. As described above, in the case of the semiconductor light-emitting device 100, the supporting substrate 11 for supporting the semiconductor layer 2 is a supporting substrate composed of p-type Si.

Next, a step (S30) of forming a two-dimensional diffraction grating is performed. To be more specific, this is a step of forming, in a layer that will form a photonic crystal layer of the semiconductor layer 2, a two-dimensional diffraction grating for diffracting light emitted by the active layer.

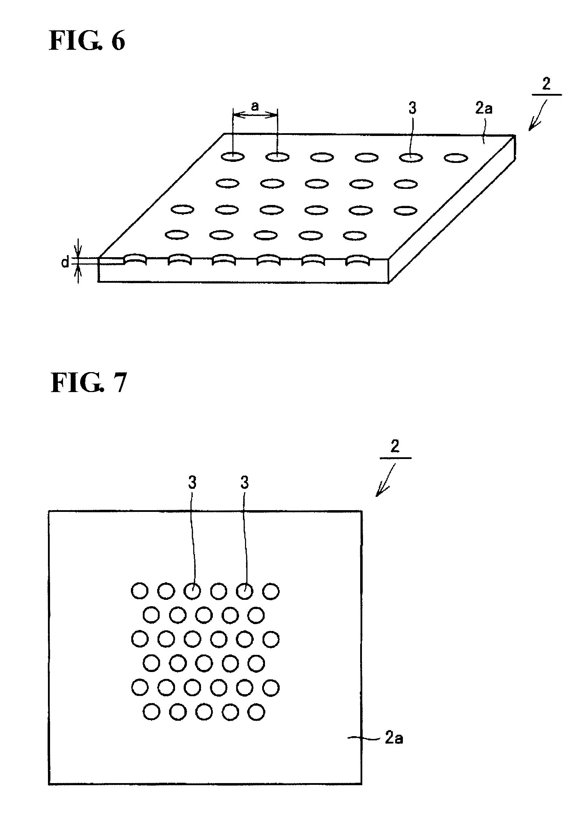

A schematic perspective view of a triangular lattice shown in Fig. 6 shows a cross-sectional structure taken in a direction intersecting the main surface of the semiconductor layer. As shown in Figs. 5 to 9, cylindrical concave portions 3 are periodically formed in two-dimensional directions, namely, one direction that extends along a main surface of a stacking surface 2a which is one of the main surfaces of the photonic crystal layer remotest from the substrate 1 among the stacking structure constituting the semiconductor layer 2, and the other direction that also extends along the main surface but intersects the aforementioned one direction. The concave portions 3 periodically formed in two-dimensional directions on the main surface of the stacking surface 2a form a two-dimensional diffraction grating. As for the method for forming the cylindrical concave portions 3 having a round shape in directions that extend along the stacking surface 2a, for example, a method including forming a mask layer by photolithography and partly removing the stacking surface 2a of the semiconductor layer 2 using the mask layer as a mask can be employed.

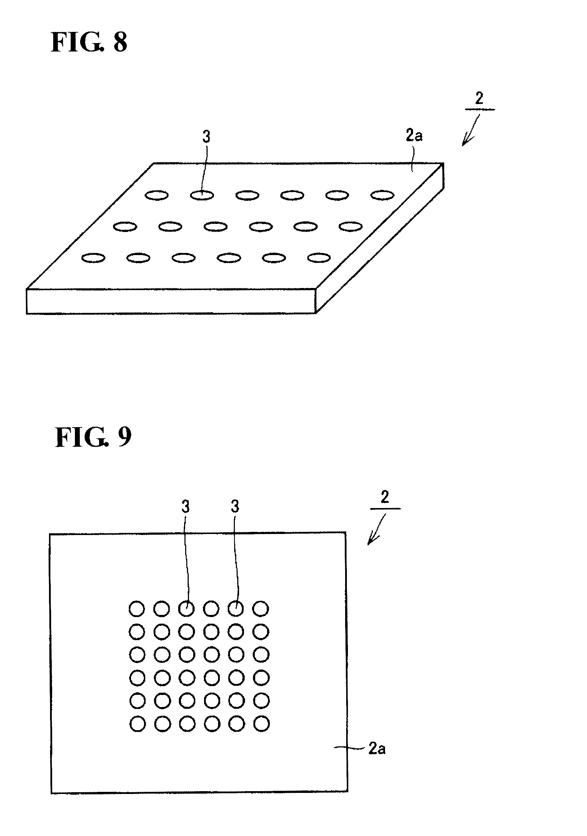

As shown in Figs. 6 and 7, the two-dimensional diffraction grating may be formed as a triangular lattice including the concave portions 3 forming a plurality of triangles in the directions that extend along the stacking surface 2a. Alternatively, as shown in Figs. 8 and 9, the two-dimensional diffraction grating may be formed as a square lattice including concave portions 3 forming a plurality of squares in the directions that extend along the stacking surface 2a. In this manner, as described above, when the wavelength of the light emitted by the active layer, the lattice constant indicating the period of the square or triangular lattice, the depth (thickness) of the concave portions 3 where the filling material is formed in a direction perpendicular to the main surface of the semiconductor layer 2, and the refractive indices of the semiconductor material and the filling material satisfy particular conditions, the two-dimensional diffraction grating can emanate light, which has been emitted by the active layer, in a desired direction at a desired intensity.

In order for the two-dimensional diffraction grating to highly efficiently yield the effect described above, the relationship 0.2λ ≤ a ≤ 10λ is preferably established where λ represents the wavelength of the light emitted by the active layer and a (refer to Fig. 6) represents the center-to-center distance (lattice constant) between adjacent concave portions 3 of the square or triangular lattice constituted by the concave portions 3 on the main surface of the semiconductor layer 2 (on the stacking surface 2a). Moreover, the relationship 0.1λ ≤ d ≤ 5λ is preferably established where d represents the thickness of the two-dimensional diffraction grating (concave portions 3) in a direction perpendicular to the main surface of the semiconductor layer 2, as shown in Fig. 6. In particular, λ is preferably 400 nm to 2 µm, a is preferably 80 nm to 20 µm, and d is preferably 40 nm to 10 µm. When the above-described conditions are satisfied, light emitted by the active layer can be highly efficiently output.

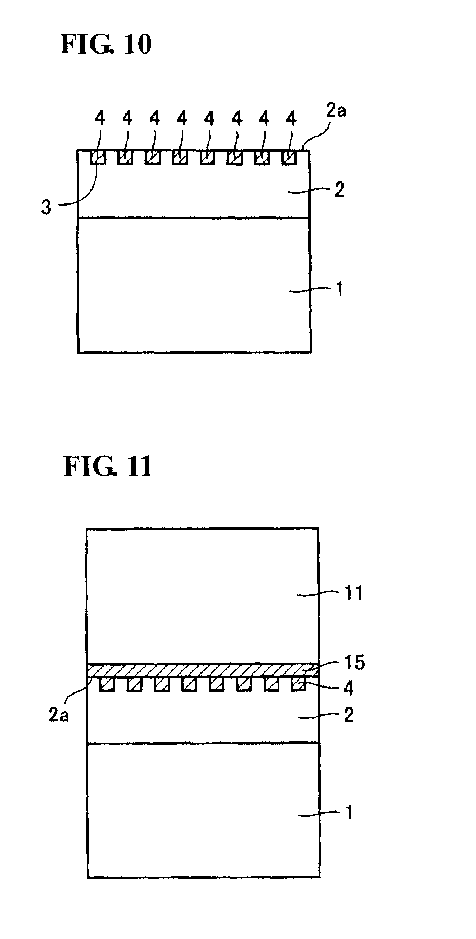

The concave portions 3 shown in Figs. 5 to 9 are filled with a material (transparent conductive films 4) that satisfies a desired condition regarding the difference in refractive index between the semiconductor material and the filling material, is electrically conductive, and is transparent to the light emitted by the active layer. Indium tin oxide (ITO) is, for example, used as a material for the transparent conductive films 4. Any known method, such as deposition using an electron beam (EB) deposition apparatus, can be used as the method for manufacturing the transparent conductive films 4 composed of ITO. As a result, an ITO contact layer including the concave portions 3 filled with the transparent conductive films 4 is formed as shown in Fig. 10.

After the two-dimensional diffraction grating is formed by the above-described step, a step of bonding a surface of the semiconductor layer 2 onto a surface of the supporting substrate 11 is performed as an attaching step (S40).

In order to form the attachment layer 15 shown in Fig. 11, AuSn solder is provided on the stacking surface 2a of the semiconductor layer 2 on which the two-dimensional diffraction grating is formed or one of the main surfaces ofthe supporting substrate 11, the one main surface opposing the semiconductor layer 2. A Au thin film layer is provided on whichever one of the stacking surface 2a of the semiconductor layer 2 on which the two-dimensional diffraction grating is formed and one of the main surfaces of the supporting substrate 11 opposing the semiconductor layer 2, not provided with the AuSn solder. Heating to a melting point of AuSn or higher is performed to yield an eutectic reaction between the AuSn and Au provided and bond AuSn to Au. In this manner, as shown in Fig. 11, one of the main surfaces of the supporting substrate 11 is bonded to the stacking surface 2a of the semiconductor layer 2 through the attachment layer 15. The thickness of the attachment layer 15 in a direction perpendicular to the main surface of the semiconductor layer 2 is preferably 1 µm to 10 µm and more preferably 3 µm to 6 µm.
At such a thickness, the bond between the semiconductor layer 2 and the supporting substrate 11 can be made firm.

Next, as shown in Fig. 2, a step (S50) of removing the semiconductor substrate is performed. The substrate 1 used to form the semiconductor layer 2 is removed by selective wet etching using, for example, a mixed solution of ammonia water and hydrogen peroxide. In the step (S60) of forming electrodes, the p-side electrode 21 and the n-side electrode 22 which are ohmic electrodes made of metal thin films are formed by, for example, vacuum vapor deposition. In the case of the semiconductor light-emitting device 100, the emission surface 2b shown in Fig. 1 is composed of, for example, an AlGaAs- or AlGaInP-based compound semiconductor; hence, a AuGeNi thin film is preferably formed as the n-side electrode 22 and a TiAu thin film is preferably formed as the p-side electrode 21, for example. The semiconductor light-emitting device 100 shown in Fig. 1 is formed as a result of the steps described above.

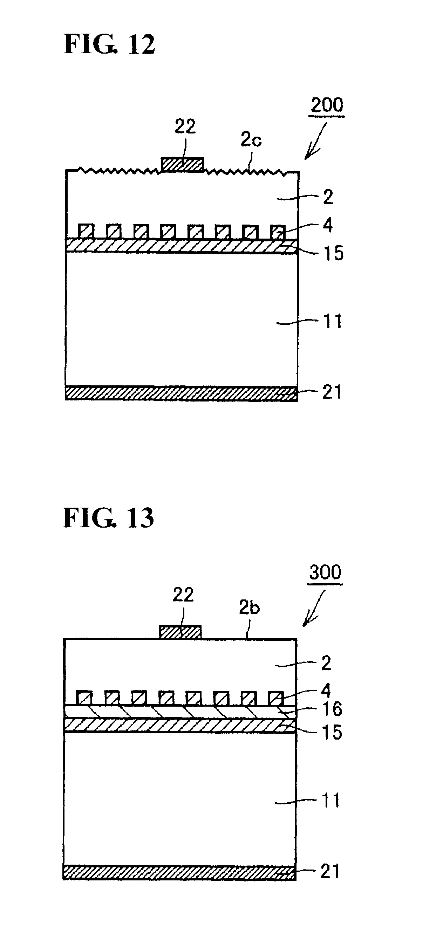

A semiconductor light-emitting device 200 shown in Fig. 12 has basically the same structure as the semiconductor light-emitting device 100 shown in Fig. 1. However, the semiconductor light-emitting device 200 differs from the semiconductor light-emitting device 100 in that an emission surface 2c is subjected to a surface roughening process. The surface roughening process can be conducted by, for example, etching using diluted nitric acid. The surface roughening process is preferably performed so that the surface roughness Ra of the emission surface 2c is 0.05 µm to 5 µm. In this manner, occurrence of total reflection at the emission surface 2c can be effectively suppressed.

### (Embodiment 2)

A semiconductor light-emitting device 300 shown in Fig. 13 has basically the same structure as the semiconductor light-emitting device 100 shown in Fig. 1. However, the semiconductor light-emitting device 300 includes a reflective film 16 composed of a metal material that reflect the light emitted by the active layer, the reflective film 16 being disposed in the region sandwiched between the semiconductor layer 2 and the supporting substrate 11, in particular, the region sandwiched between the two-dimensional diffraction grating formed in the semiconductor layer 2 and the attachment layer 15. The semiconductor light-emitting device 300 differs from the semiconductor light-emitting device 100 in this point. Note that "reflective" means that the light incident on the reflective film 16 and having the wavelength emitted from the active layer is reflected at a reflectivity of 80% or more.

As shown in Fig. 13, when the semiconductor light-emitting device 300 includes the reflective film 16 provided under (the supporting substrate 11 side of) the two-dimensional diffraction grating of the semiconductor layer 2, the light, which has been emitted by the active layer, has entered the two-dimensional diffraction grating, and is about to enter the supporting substrate 11 through the attachment layer 15, can be reflected by the reflective film 16. Since the direction in which light travels is changed from downward to upward in Fig. 13 by the reflection, the efficiency of emanating the light from the emission surface 2b can be increased and the intensity of outputting light from the emission surface 2b in a particular direction can be further increased.

The reflective film 16 is preferably composed of a material that contains at least one selected from the group consisting of aluminum, gold, platinum, silver, copper, and chromium. The reflective film 16 composed of these metal materials can reflect light, e.g., infrared and visible light, emitted by the active layer at a high reflectivity of 80% or more.

The method for manufacturing the semiconductor light-emitting device 300 is basically the same as the method for manufacturing the semiconductor light-emitting device 100 shown in Fig. 2. However, as described above, since the semiconductor light-emitting device 300 includes the reflective film 16, the method for manufacturing the semiconductor light-emitting device 300 includes an additional step of forming the reflective film 16 compared to the method for manufacturing the semiconductor light-emitting device 100.

The method for manufacturing the semiconductor light-emitting device 300 is basically the same as the method for manufacturing the semiconductor light-emitting device 100 shown in Fig. 2. However, in the method for manufacturing the semiconductor light-emitting device 300, a step (S30) of forming the two-dimensional diffraction grating shown in Fig. 2 is performed to form a structure shown in Fig. 10 and then the reflective film 16 composed of a material containing at least one selected from the group consisting of aluminum, gold, platinum, silver, copper, and chromium is formed on the stacking surface 2a shown in Fig. 10 by, for example, vacuum vapor deposition. The thickness of the reflective film 16 in a direction perpendicular to the main surface of the semiconductor layer 2 is preferably 0.05 µm to 2 µm. At such a thickness, the reflective film 16 can effectively reflect light.

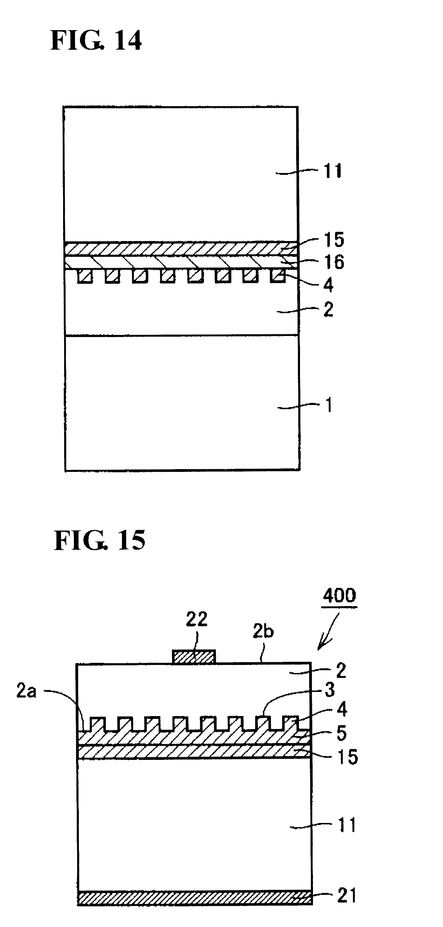

Subsequently, AuSn solder for forming the attachment layer 15 is provided on the main surface of the reflective film 16 not opposing the semiconductor layer 2 or on the main surface of the supporting substrate 11 opposing the semiconductor layer 2 as in the attaching step (S40) described above. A Au thin film layer is provided to whichever one of the main surface of the reflective film 16 not opposing the semiconductor layer 2 and the main surface of the supporting substrate 11 opposing the semiconductor layer 2, not provided with the AuSn solder. Then as shown in Fig. 14, the main surface of the reflective film 16 formed on the main surface of the semiconductor layer 2 is attached to the main surface of the supporting substrate 11 through the AuSn solder and the solder is melted by heating to connect the supporting substrate 11 to the semiconductor layer 2. As a result, the attachment layer 15 composed of the AuSn solder is formed. Subsequently, as with the method for manufacturing the semiconductor light-emitting device 100, processes of removing the substrate 1 and forming the electrodes are conducted to form the semiconductor light-emitting device 300 shown in Fig. 13. The method for manufacturing the semiconductor light-emitting device 300 differs from the method for manufacturing the semiconductor light-emitting device 100 in the above-described points.

The embodiment 2 differs from the embodiment 1 only in the respective points described above. In other words, the structures, conditions, processes, and effects not described in the embodiment 2 are pursuant to the embodiment 1.

### (Embodiment 3)

A semiconductor light-emitting device 400 shown in Fig. 15 has basically the same structure as the semiconductor light-emitting device 100 shown in Fig. 1. However, in the semiconductor light-emitting device 400, the same material as the transparent conductive films 4 filling the concave portions 3 constituting the semiconductor layer 2 (two-dimensional diffraction grating) is disposed on the entire stacking surface 2a on which the two-dimensional diffraction grating is formed so as to form a transparent electrically conductive film 5. The semiconductor light-emitting device 400 differs from the semiconductor light-emitting device 100 in this point.

The material for the transparent electrically conductive film 5 may be arranged to be only the transparent conductive films 4 filling the concave portions 3 of the two-dimensional diffraction grating as in the case of the semiconductor light-emitting device 100. However, as in the semiconductor light-emitting device 400, the material may be disposed as the transparent electrically conductive film 5 covering the entire surface of the stacking surface 2a in addition to the transparent conductive films 4 filling the concave portions 3 of the two-dimensional diffraction grating. In this manner, since the main surface of the attachment layer 15 is bonded to oppose the main surface of the transparent electrically conductive film 5, the main surface of the attachment layer 15 is connected only to the main surface of the transparent electrically conductive film 5 in this region. As a result, the entire surface of the semiconductor layer 2 makes an ohmic contact with the entire surface of the transparent electrically conductive film 5, and the operation voltage of the semiconductor light-emitting device 100 can be lowered.

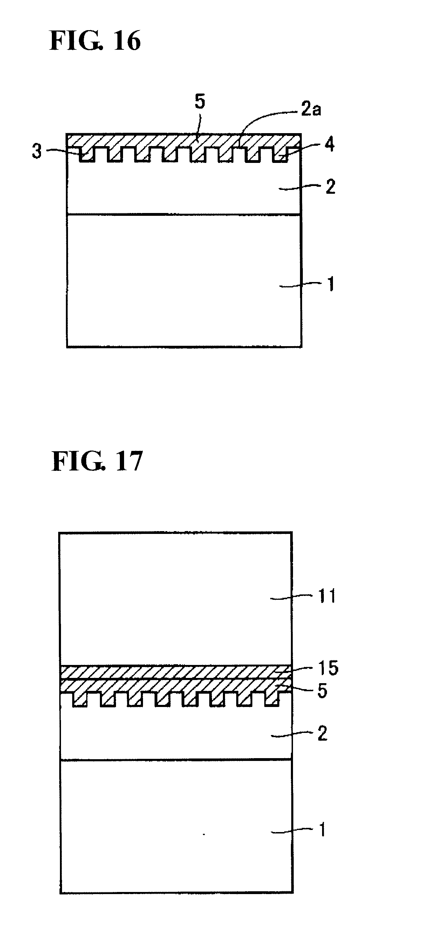

The method for manufacturing the semiconductor light-emitting device 400 is basically the same as the method for manufacturing the semiconductor light-emitting device 100 shown in Fig. 2. However, the method for manufacturing the semiconductor light-emitting device 400 includes an additional step of forming the transparent electrically conductive film 5 compared to the method for manufacturing the semiconductor light-emitting device 100. In the step (S30) of forming the two-dimensional diffraction grating shown in Fig. 2, after the structure shown in Fig. 5 is formed, the transparent conductive films 4 and the transparent electrically conductive film 5 are formed as shown in Fig. 16. The transparent electrically conductive film 5 is preferably formed to cover the entire surface of the stacking surface 2a, that is, the regions where the concave portions 3 are filled with the transparent conductive films 4 and the regions where the concave portions 3 are not formed. The material for the transparent electrically conductive film 5 is preferably the same as the material for the transparent conductive films 4 filling the concave portions 3. Thus, the transparent electrically conductive film 5 can be formed as shown in Fig. 16 by filling the concave portions 3 in the stacking surface 2a with the filling material to form the transparent conductive films 4 while providing the same material as the filling material on the regions of the stacking surface 2a where the concave portions 3 are absent in step (S30) shown in Fig. 2.

Subsequently, as in the method for manufacturing the semiconductor light-emitting device 100, the supporting substrate 11 is attached onto the semiconductor layer 2 by using the attachment layer 15 to form the structure shown in Fig. 17. Then the substrate 1 is removed and electrodes are formed to form the semiconductor light-emitting device 400 shown in Fig. 15. The method for manufacturing the semiconductor light-emitting device 400 differs from the method for manufacturing the semiconductor light-emitting device 100 only in the above-described points.

The embodiment 3 differs from the embodiment 1 only in the respective points described above. In other words, the structures, conditions, processes, and effects not described in the embodiment 3 are pursuant to the embodiment 1.

### (Embodiment 4)

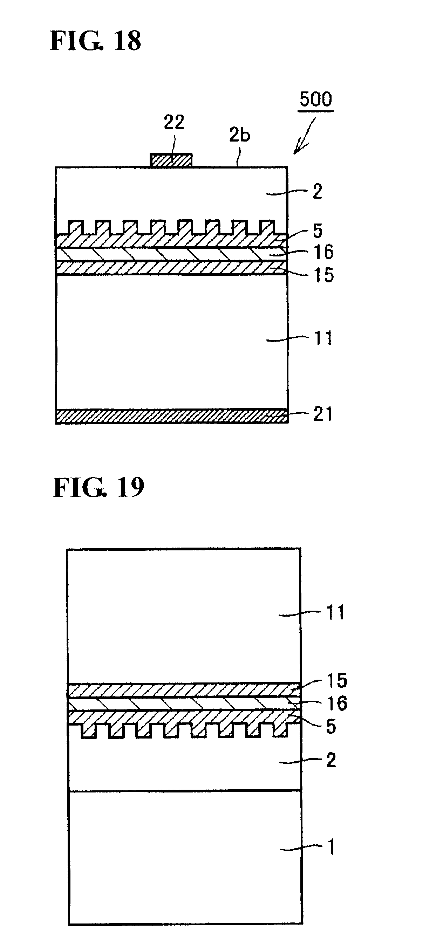

A semiconductor light-emitting device 500 shown in Fig. 18 has basically the same structure as the semiconductor light-emitting device 400 shown in Fig. 3. However, as with the semiconductor light-emitting device 300 shown in Fig. 2, the semiconductor light-emitting device 500 includes a reflective film 16 composed of a metal material that reflects light emitted by the active layer, the reflective film 16 being disposed in the region sandwiched between the semiconductor layer 2 and the supporting substrate 11, in particular, the region sandwiched between the transparent electrically conductive film 5 and the attachment layer 15. The semiconductor light-emitting device 500 differs from the semiconductor light-emitting device 400 in this point.

As with the semiconductor light-emitting device 300, the semiconductor light-emitting device 500 includes the reflective film 16 and thus the efficiency of emanating light from the emission surface 2b can be increased and the intensity of outputting light from the emission surface 2b in a particular direction can be further increased.

The method for manufacturing the semiconductor light-emitting device 500 is basically the same as the method for manufacturing the semiconductor light-emitting device 400 described above. However, as described above, since the semiconductor light-emitting device 500 includes the reflective film 16, the method for manufacturing the semiconductor light-emitting device 500 includes an additional step of forming the reflective film 16 compared to the method for manufacturing the semiconductor light-emitting device 400.

A step (S30) of forming the two-dimensional diffraction grating in Fig. 2 is conducted to form the structure shown in Fig. 16. Subsequently, the reflective film 16 composed of a material containing at least one selected from the group consisting of aluminum, gold, platinum, silver, copper, and chromium is formed on the main surface of the transparent electrically conductive film 5 shown in Fig. 16, the main surface not opposing the semiconductor layer 2, by vacuum vapor deposition, for example. Then AuSn solder is provided on the main surface of the reflective film 16 not opposing the semiconductor layer 2 or the main surface of the supporting substrate 11 opposing the semiconductor layer 2 so as to form the attachment layer 15 as in the attaching step (S40) described above. A Au thin film layer is provided on whichever one of the main surface of the reflective film 16 not opposing the semiconductor layer 2 and the main surface of the supporting substrate 11 opposing the semiconductor layer 2, not provided with the AuSn solder. Heating to a melting point of AuSn or higher is performed to yield an eutectic reaction between AuSn and Au and bond AuSn onto Au. As a result, the attachment layer 15 shown in Fig. 19 is formed.

Subsequently, as in the method for manufacturing the semiconductor light-emitting device 100, the substrate 1 is removed and the electrodes are formed to form the semiconductor light-emitting device 500 shown in Fig. 18. The method for manufacturing the semiconductor light-emitting device 500 differs from the method for manufacturing the semiconductor light-emitting device 400 in the points described above.

The embodiment 4 differs from the embodiment 3 only in the respective points described above. In other words, the structures, conditions, processes, and effects not described in the embodiment 4 are pursuant to the embodiment 3.

### (Embodiment 5)

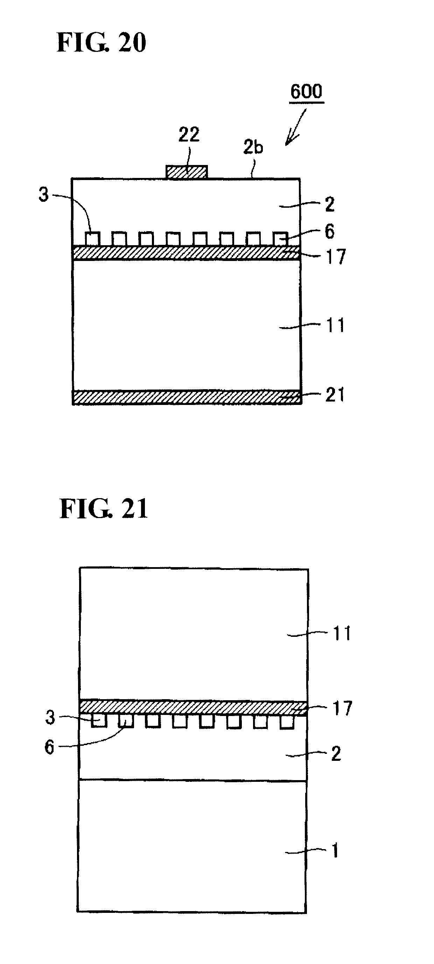

A semiconductor light-emitting device 600 shown in Fig. 20 has basically the same structure as that of the semiconductor light-emitting device 100 shown in Fig. 1. However, in the semiconductor light-emitting device 600, the concave portions 3 constituting the two-dimensional diffraction grating form air holes 6 filled with air. The semiconductor light-emitting device 600 differs from the semiconductor light-emitting device 100 in this point.

In the semiconductor light-emitting device 600, the two-dimensional diffraction grating is constituted by air and a semiconductor material periodically arranged on the main surface of the semiconductor layer 2. In this case also, the light emitted by the active layer can be diffracted under desired conditions and can be highly efficiently output under desired conditions due to the difference in refractive index between air and the semiconductor material with respect to the directions extending along the main surface of the semiconductor layer 2. The conduction between the n-side electrode 22 and the p-side electrode 21 is blocked by portions occupied by the air holes 6 in the region of the photonic crystal layer of the semiconductor light-emitting device 600 along the main surface where the two-dimensional diffraction grating is disposed. However, even in this region of the two-dimensional diffraction grating, conduction can be achieved between the n-side electrode 22 and the p-side electrode 21 in the regions occupied by the semiconductor material constituting the photonic crystal layer (regions other than the regions where the air holes 6 exist). Thus, when the semiconductor light-emitting device 600 is viewed as a whole, conduction between the n-side electrode 22 and the p-side electrode 21 can be achieved. Accordingly, normal operation of the semiconductor light-emitting device 600 is not obstructed even when the concave portions 3 are filled with dielectric films 7.

Since the concave portions 3 of the two-dimensional diffraction grating are formed as the air holes 6 filled with air in the semiconductor light-emitting device 600, there is no need to conduct a process of filling the transparent electrically conductive films 4 included in the step (S30) of forming the two-dimensional diffraction grating of the method for manufacturing the semiconductor light-emitting device 100, for example. There is no need for a process for filling the interiors of the concave portions 3 in order to fill the concave portions 3 with air as long as the process is conducted in air. Accordingly, the method for manufacturing the semiconductor light-emitting device 600 can shorten the production takt time compared to the method for manufacturing the semiconductor light-emitting device 100 and reduce the material cost. Accordingly, the method for manufacturing the semiconductor light-emitting device 600 can reduced the process cost.

The method for manufacturing the semiconductor light-emitting device 600 is basically the same as the method for manufacturing the semiconductor light-emitting device 100 shown in Fig. 2. However, the method for manufacturing the semiconductor light-emitting device 600 slightly differs from the method for manufacturing the semiconductor light-emitting device 100 in the step (S20) of preparing the supporting substrate and the step (S30) of forming the two-dimensional diffraction grating shown in Fig. 2. In the step (S20) of preparing the supporting substrate, as shown in Fig. 21, an ohmic layer that can make an ohmic contact with the supporting substrate 11 and a AuSn layer similar to that of the semiconductor light-emitting device 100 described above are formed on one of the main surfaces of the supporting substrate 11. An ohmic layer that can make an ohmic connection with the semiconductor layer 2 and a Au thin film layer the same as that of the semiconductor light-emitting device 100 are formed on the stacking surface 2a of the semiconductor layer 2 in regions where the concave portions 3 are not formed. After forming these layers, as shown in Fig. 21, the supporting substrate 11 is attached onto the semiconductor layer 2 in a manner similar to the semiconductor light-emitting device 100 or the like. The ohmic layer contacting the semiconductor layer 2 is preferably a thin film having a Au/Zn/Ti/Au stacking structure, for example. Furthermore, a thin film composed of a AuBe alloy, for example, may be formed. In this manner, even when the regions occupied by the air holes 6 constituting the two-dimensional diffraction grating obstruct the conduction between the p-side electrode 21 and the n-side electrode 22, sufficient conduction can be established between the p-side electrode 21 and the n-side electrode 22 in the regions occupied by the semiconductor material constituting the two-dimensional diffraction grating since the attachment layer 17 forms an ohmic junction composed of two metal layers.

In the step (S30) of forming the two-dimensional diffraction grating of the method for manufacturing the semiconductor light-emitting device 600, the concave portions 3 having structures shown in Fig. 5 are formed. However, no filling material is introduced inside the concave portions 3. In this state, the stacking surface 2a of the semiconductor layer 2 shown in Fig. 5 is attached onto the main surface of the attachment layer 17 formed on the supporting substrate 11 in air as shown in Fig. 21 in the attaching step (S40). As a result, the interiors of the concave portions 3 covered with the attachment layer 17 can be filled with air. Subsequently, as in the method for manufacturing the semiconductor light-emitting device 100, the substrate 1 is removed and the electrodes are formed to form the semiconductor light-emitting device 600 shown in Fig. 20. The method for manufacturing the semiconductor light-emitting device 600 differs from the method for manufacturing the semiconductor light-emitting device 100 in the above-described points.

The embodiment 5 differs from the embodiment 1 only in the respective points described above. In other words, the structures, conditions, processes, and effects not described in the embodiment 5 are pursuant to the embodiment 1.

### (Embodiment 6)

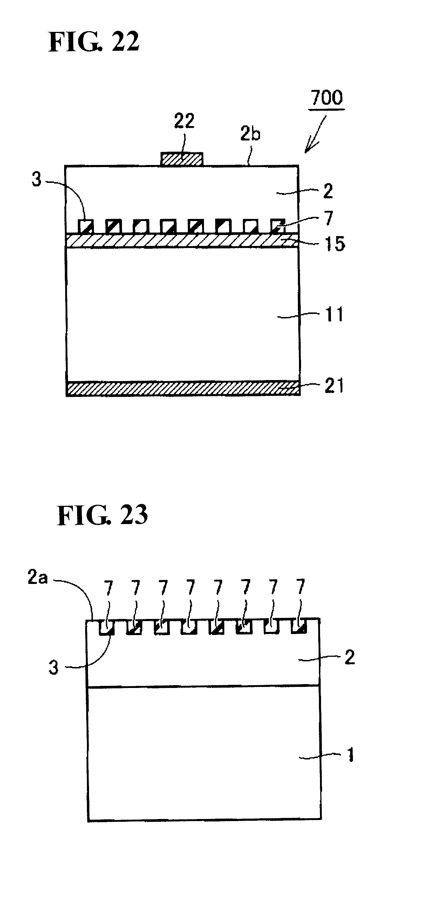

A semiconductor light-emitting device 700 shown in Fig. 22 has basically the same structure as the semiconductor light-emitting device 100 shown in Fig. 1. However, in the semiconductor light-emitting device 700, the filling material filling the concave portions 3 constituting the two-dimensional diffraction grating is dielectric films 7. The semiconductor light-emitting device 700 differs from the semiconductor light-emitting device 100 in this point.

The dielectric films 7 are preferably composed of a material containing at least one selected from the group consisting of silicon oxide, magnesium fluoride, calcium fluoride, barium fluoride, lithium fluoride, and zirconium oxide. Since these materials are transparent to the light having the wavelength emitted by the active layer, the two-dimensional diffraction grating can smoothly diffract light when these materials are used as the material for the two-dimensional diffraction grating.

As described in the embodiments above, in the case where the transparent conductive films 4 are used as the filling material that fills the concave portions 3, a material that is transparent to the infrared or visible light emitted by the active layer and that is electrically conductive is preferably used. Accordingly, the range of choice for the material that can be used as the transparent conductive films 4 and the transparent electrically conductive film 5 is narrow. Thus, as in the semiconductor light-emitting device 700 of the embodiment 6, the concave portions 3 are filled with the dielectric films 7 composed of a dielectric material. As a result, the range of choice for the material that can be used to fill the concave portions 3 can be widened.

Due to the presence of the dielectric films 7, the conduction between the n-side electrode 22 and the p-side electrode 21 is blocked in the region that extends along the main surface of the photonic crystal layer of the semiconductor light-emitting device 700, the main surface being provided with the two-dimensional diffraction grating. However, even in this region of the two-dimensional diffraction grating, conduction between the n-side electrode 22 and the p-side electrode 21 is possible in the region composed of the semiconductor material constituting the photonic crystal layer. Thus, when the semiconductor light-emitting device 700 is viewed as a whole, conduction between the n-side electrode 22 and the p-side electrode 21 can be achieved. Accordingly, normal operation of the semiconductor light-emitting device 700 is not obstructed even when the concave portions 3 are filled with the dielectric films 7.

The method for manufacturing the semiconductor light-emitting device 700 is basically the same as the method for manufacturing the semiconductor light-emitting device 100. However, as described above, the semiconductor light-emitting device 700 differs from the semiconductor light-emitting device 100 in that the concave portions 3 are filled with the dielectric films 7 as shown in Fig. 23. Thus, in the step (S30) of forming the two-dimensional diffraction grating shown in Fig. 2 of the method for manufacturing the semiconductor light-emitting device 700, the concave portions 3 are filled with the dielectric films 7 after the structure shown in Fig. 5 is formed so as to form a structure shown in Fig. 23. In filling the concave portions 3 with the dielectric films 7, any known method may be employed to form the dielectric films 7.

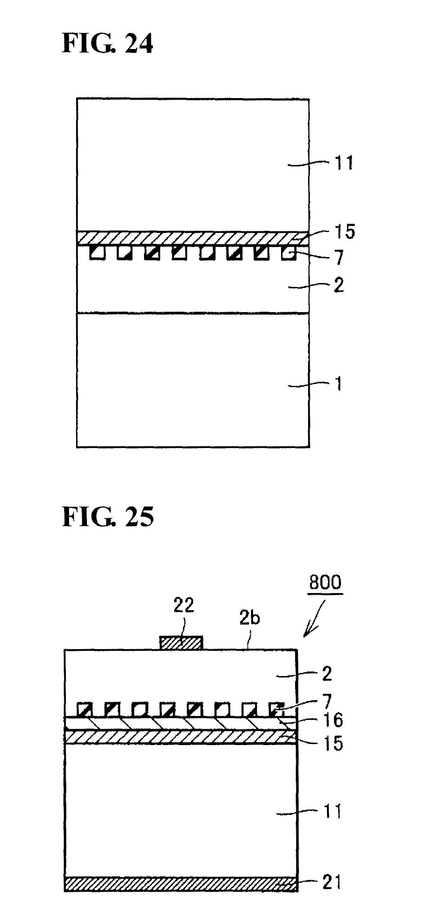

In the attaching step (S40), as shown in Fig. 24, the semiconductor layer 2 is bonded onto the supporting substrate 11 using the attachment layer 15 composed of AuSn, as in Fig. 11 of the method for manufacturing the semiconductor light-emitting device 100. Subsequently, as with the method for manufacturing the semiconductor light-emitting device 100, the substrate 1 is removed and the electrodes are formed to form the semiconductor light-emitting device 700 shown in Fig. 22. The method for manufacturing the semiconductor light-emitting device 700 differs from the method for manufacturing the semiconductor light-emitting device 100 in this point.

The embodiment 6 differs from the embodiment 1 only in the respective points described above. In other words, the structures, conditions, processes, and effects not described in the embodiment 6 are pursuant to the embodiment 1.

### (Embodiment 7)

A semiconductor light-emitting device 800 shown in Fig. 25 has basically the same structure as the semiconductor light-emitting device 700 shown in Fig. 22. However, the semiconductor light-emitting device 800 includes a reflective film 16 composed of a metal material that reflects light emitted by the active layer, the reflective film 16 being disposed in the region sandwiched by the semiconductor layer 2 (two-dimensional diffraction grating) and the supporting substrate 11, in particular, the region sandwiched between the transparent electrically conductive film 5 and the attachment layer 15, as with the semiconductor light-emitting device 300 shown in Fig. 2. The semiconductor light-emitting device 800 differs from the semiconductor light-emitting device 700 in this point.

As with the semiconductor light-emitting device 700, the semiconductor light-emitting device 800 includes the reflective film 16 and thus the efficiency at which the light is emanated from the emission surface 2b can be increased and the intensity of outputting light from the emission surface 2b in a particular direction can be further increased.

The method for manufacturing the semiconductor light-emitting device 800 is basically the same as the method for manufacturing the semiconductor light-emitting device 700. However, as described above, since the semiconductor light-emitting device 800 includes the reflective film 16, the method for manufacturing the semiconductor light-emitting device 800 includes an additional step of forming the reflective film 16 compared to the method for manufacturing the semiconductor light-emitting device 700.

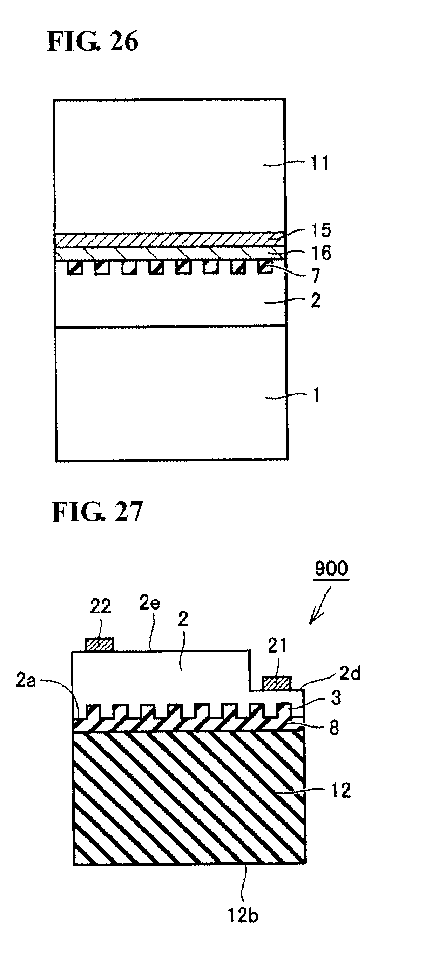

A step (S30) of forming the two-dimensional diffraction grating in Fig. 2 is performed to form the structure shown in Fig. 23 and then a reflective film 16 composed of a material containing at least one selected from the group consisting of aluminum, gold, platinum, silver, copper, and chromium is formed on the stacking surface 2a shown in Fig. 23 by, for example, vacuum vapor deposition. Subsequently, AuSn solder is provided on the main surface of the reflective film 16 not opposing the semiconductor layer 2 or the main surface of the supporting substrate 11 opposing the semiconductor layer 2 as in the attaching step (S40) so as to form the attachment layer 15. A Au thin film is provided on whichever one of the main surface of the reflective film 16 not opposing the semiconductor layer 2 and the main surface of the supporting substrate 11 opposing the semiconductor layer 2, not provided with the AuSn solder. Then, as shown in Fig. 26, the main surface ofthe reflective film 16 formed on the main surface of the transparent electrically conductive film 5 is attached to the main surface of the supporting substrate 11 through AuSn solder and the solder is heated to form the attachment layer 15. Subsequently, as with the method for manufacturing the semiconductor light-emitting device 100, the substrate 1 is removed and the electrodes are formed to form the semiconductor light-emitting device 800 shown in Fig. 25. The method for manufacturing the semiconductor light-emitting device 800 differs from the method for manufacturing the semiconductor light-emitting device 700 in the points described above.

The embodiment 7 differs from the embodiment 6 only in the respective points described above. In other words, the structures, conditions, processes, and effects not described in the embodiment 7 are pursuant to the embodiment 6.

### (Embodiment 8)

A semiconductor light-emitting device 900 shown in Fig. 27 includes a transparent supporting substrate 12 transparent with respect to the wavelength of light emitted by the active layer, the transparent supporting substrate 12 serving as a supporting substrate for supporting the semiconductor layer 2. The stacking surface 2a of the semiconductor layer 2 is bonded to the main surface of the transparent supporting substrate 12 with a transparent adhesive layer 8. The main surface of the transparent supporting substrate 12, the main surface not opposing the semiconductor layer 2 (the lower main surface in Fig. 27) is a main surface 12b. Both the p-side electrode 21 and the n-side electrode 22 are formed on the surface of the semiconductor layer 2 (p-type semiconductor layer surface 2d and n-type semiconductor layer surface 2e).

All of the semiconductor light-emitting devices of the embodiments 1 to 7 described above use, as the supporting substrate 11, a material that is opaque with respect to emitted light. Accordingly, the main surface of the semiconductor layer 2 not opposing the supporting substrate 11 (the upper main surface in each drawing) serves as the emission surface 2b. According to the semiconductor light-emitting device 900, a material transparent with respect to the emitted light is used in the supporting substrate. Thus, the n-type semiconductor layer surface 2e not opposing the transparent supporting substrate 12 may be used as the emission surface or the main surface 12b of the transparent supporting substrate 12 may be used as the emission surface. This increases the degree of freedom in designing the semiconductor light-emitting device. When the n-type semiconductor layer surface 2e not opposing the transparent supporting substrate 12 is used as the emission surface, the main surface 12b of the transparent supporting substrate 12 is fixed onto a lead frame by using a silver paste. With this structure, the light traveling from the active layer toward the main surface 12b is reflected by the silver paste and output from the n-type semiconductor layer surface 2e, thereby increasing the intensity of optical output. Since the material constituting the transparent supporting substrate 12 is poorly electrically conductive, both the p-side electrode 21 and the n-side electrode 22 of the semiconductor light-emitting device 900 are formed on the semiconductor layer 2 side.

The semiconductor light-emitting device 900 may be configured such that the light emitted by the active layer of the semiconductor layer 2 reaches the transparent supporting substrate 12 through the transparent adhesive layer 8 and is output from the main surface 12b. Alternatively, the light may be reflected by the silver paste applied on the main surface 12b and output from the n-type semiconductor layer surface 2e. Accordingly, a material transparent to light emitted by the active layer is preferably used in the transparent adhesive layer 8 as with the transparent supporting substrate 12.

A material that is transparent to the light emitted by the active layer and that has adhesiveness and can bond the stacking surface 2a of the semiconductor layer 2 onto the main surface of the transparent supporting substrate 12 is preferably used for the transparent adhesive layer 8. In this manner, the transparent adhesive layer 8 achieves functions of transmitting light emitted by the active layer and bonding the semiconductor layer 2 onto the transparent supporting substrate 12.

The same material as the material for the transparent adhesive layer 8 is filled in the concave portions 3 constituting the two-dimensional diffraction grating of the semiconductor light-emitting device 900. In this manner, emitted light can be diffracted by the transparent adhesive layer 8 filling the concave portions 3 of the two-dimensional diffraction grating and guided to a desired direction (direction toward the transparent supporting substrate 12).

To be more specific, the transparent adhesive material used in the transparent adhesive layer 8 is preferably composed of a material containing at least one selected from the group consisting of polyimide (PI), epoxy, silicone, and perfluorocyclobutane (PFCB). The transparent adhesive material may be used only as the filling material for filling the concave portions 3 and another material may be used to bond the stacking surface 2a of the semiconductor layer 2 onto the main surface of the transparent supporting substrate 12.

The transparent supporting substrate 12 is preferably composed of a material containing at least one selected from the group consisting of sapphire, gallium phosphide, quartz, and spinel. When these materials are used in the transparent supporting substrate 12, light emitted by the semiconductor layer 2 can be propagated to the transparent supporting substrate 12 through the transparent adhesive layer 8 and output from the main surface 12b at a high efficiency. When the substrate is fixed onto the lead frame by application of a silver paste, light can be reflected by the silver paste and output from the n-type semiconductor layer surface 2e at a high efficiency. The transparent supporting substrate 12 in the semiconductor light-emitting device 900 is, for example, a supporting substrate composed of sapphire. Since the semiconductor light-emitting device 900 is operated by establishing conduction between the p-side electrode 21 and the n-side electrode 22, the transparent adhesive layer 8 and the transparent supporting substrate 12 may be composed of a non-conductive material.

According to the semiconductor light-emitting device of the embodiment 8, light emitted by the active layer travels toward the main surface 12b of the transparent supporting substrate 12. Thus, the two-dimensional diffraction grating having a function of diffracting the emitted light may be formed in the bonding interface region on the semiconductor layer 2 side (region at a particular depth from the main surface of the semiconductor layer 2 bonded onto the transparent adhesive layer 8 toward the semiconductor layer 2 side), as shown in Fig. 27. Alternatively, the two-dimensional diffraction grating may be formed in the bonding interface region at the transparent supporting substrate 12 side (region at a particular depth from the main surface of the transparent supporting substrate 12 bonded to the transparent adhesive layer 8 toward the transparent supporting substrate 12 side).

According to the semiconductor light-emitting device 900 of the embodiment 8 also, the main surface of the semiconductor layer 2 on which the two-dimensional diffraction grating is formed is arranged to oppose the transparent adhesive layer 8 as with the semiconductor light-emitting devices of the embodiments 1 to 7 above. Accordingly, the two-dimensional diffraction grating is not formed on the main surface 12b, which is the main surface of the transparent supporting substrate 12, and the p-type semiconductor layer surface 2d and n-type semiconductor layer surface 2e on which the electrodes are formed. Thus, the two-dimensional diffraction grating can be formed on the entire surface of the main surface.

Next, a method for manufacturing the semiconductor light-emitting device 900 is described. The method for manufacturing the semiconductor light-emitting device 900 basically follows the same steps as those shown in Fig. 2. In the step (S10) of forming the semiconductor layer, the semiconductor layer 2 shown in Fig. 4 is formed. In the step (S20) of preparing the supporting substrate, the transparent supporting substrate 12 composed of sapphire is prepared in the case of manufacturing the semiconductor light-emitting device 900, as described above.

In the step (S30) of forming the two-dimensional diffraction grating, concave portions 3 are formed on the main surface of the stacking surface 2a of the semiconductor layer 2 as shown in Fig. 5. Alternatively, the concave portions 3 may be formed on one of the main surfaces of the transparent supporting substrate 12.

In the step (S30) of forming the two-dimensional diffraction grating, after the structure shown in Fig. 5 is formed, the concave portions 3 are filled with the transparent adhesive layer 8. At the same time, a transparent adhesive material for forming the transparent adhesive layer 8 covering the surface of the two-dimensional diffraction grating including the concave portions 3 is also provided.

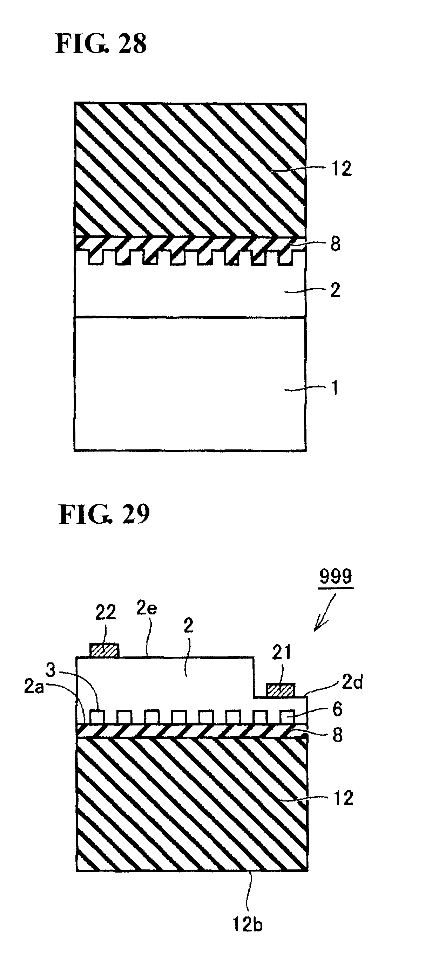

Subsequently, as in the methods for manufacturing the semiconductor light-emitting devices described above, in the attaching step (S40), the transparent adhesive layer 8 arranged to cover the entire surface of the two-dimensional diffraction grating is used instead of the attachment layer 15 to bond the semiconductor layer 2 onto the transparent supporting substrate 12. As a result, a structure shown in Fig. 28 is formed.

Next, in the step (S50) of removing the semiconductor substrate, the substrate 1 is removed. Then in the step (S60) of forming the electrodes, the semiconductor layer 2 is partly removed before forming the p-side electrode 21 and the n-side electrode 22 by, for example, vacuum vapor deposition, as shown in Fig. 27. This is because the transparent supporting substrate 12 of the semiconductor light-emitting device 900 is not electrically conductive and thus the electrodes must be formed on the surface of the semiconductor layer 2. The stacking structure of the semiconductor layer 2 shown in Fig. 27 includes a region composed of a p-type semiconductor material, such as a p-type cladding layer, at the side near the transparent supporting substrate 12 (the lower side in Fig. 27) and a region composed of an n-type semiconductor material, such as an n-type cladding layer, at the side remote from the transparent supporting substrate 12 (the upper side in Fig. 27).
In this case, etching is performed on the region of part (right side in Fig. 27) of the semiconductor layer 2 so as to expose the p-type cladding layer and form the p-side electrode 21. In this manner, the p-side electrode 21 can be formed by, for example, vacuum vapor deposition, on the surface of the exposed region (the p-type semiconductor layer surface 2d), and the n-side electrode 22 can be formed by, for example, vacuum vapor deposition on the surface of the region of the surface of the semiconductor layer 2 not subjected to etching (n-type semiconductor layer surface 2e). As a result of these processes, the semiconductor light-emitting device 900 shown in Fig. 27 is formed.

The embodiment 8 differs from the embodiment 1 only in the respective points described above, In other words, the structures, conditions, processes, and effects not described in the embodiment 8 are pursuant to the embodiment 1.

### (Embodiment 9)

A semiconductor light-emitting device 999 shown in Fig. 29 has basically the same structure as the semiconductor light-emitting device 900 shown in Fig. 27. However, in the semiconductor light-emitting device 999, the concave portions 3 constituting the two-dimensional diffraction grating form air holes 6 filled with air. This is the difference between the semiconductor light-emitting device 999 and the semiconductor light-emitting device 900.

According to the structure shown in Fig. 29, as with the semiconductor light-emitting device 600 described above, for example, the region on which the transparent adhesive layer 8 is disposed can be made smaller than that of the semiconductor light-emitting device 900, and thus the process cost can be reduced.

In the embodiment 9 of the present invention, for example, the attachment layer 15 may be used instead of the transparent adhesive layer 8 as the material for bonding the stacking surface 2a of the semiconductor layer 2 onto the main surface of the transparent supporting substrate 12. However, unless a transparent material transparent to the emitted light is used in the attachment layer 15, the light output surface is the surface side of the semiconductor layer 2 on which the n-side electrode 22 etc., are formed.

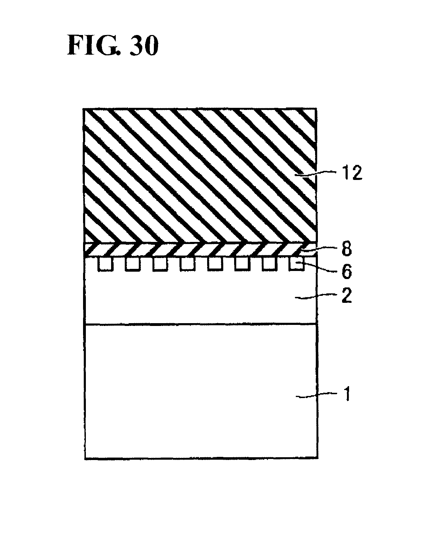

The method for manufacturing the semiconductor light-emitting device 999 is basically the same as the method for manufacturing the semiconductor light-emitting device 900 described above. However, as described above, the concave portions 3 constituting the two-dimensional diffraction grating of the semiconductor light-emitting device 999 form air holes 6. Thus, in the step (S30) of forming the two-dimensional diffraction grating, the process of filling the concave portions 3 with the transparent adhesive material forming the transparent adhesive layer 8 is not performed and the attaching step (S40) is performed in air. As a result, the structure shown in Fig. 30 is formed. Subsequently, the same process as the method for manufacturing the semiconductor light-emitting device 900 is conducted. Figure 30 differs from Fig. 28 in that the concave portions 3 are forming the air holes 6. The method for manufacturing the semiconductor light-emitting device 999 differs from the method for manufacturing the semiconductor light-emitting device 900 in this point.

The embodiment 9 differs from the embodiment 8 only in the respective points described above. In other words, the structures, conditions, processes, and effects not described in the embodiment 9 are pursuant to the embodiment 8.

The emission surfaces of all of the semiconductor light-emitting devices of the respective embodiments described above may be subjected a surface roughening process to increase the surface roughness Ra so that the total reflection of light at the emission surface can be suppressed.

The embodiments disclosed in this description are only exemplary and should not be understood as limiting the scope of the present invention. The scope of the present invention is defined not by the description above but by the claims below and includes all equivalents of what is claimed and all modifications within the scope of the invention.

### INDUSTRIAL APPLICABILITY

The present invention is particularly useful as the technology that can improve the efficiency of outputting light emitted by a semiconductor light-emitting device.

## Claims

1. A semiconductor light-emitting device comprising:
a semiconductor layer including an active layer;
a supporting substrate for supporting the semiconductor layer; and
an attachment layer for bonding a main surface of the semiconductor layer onto a main surface of the supporting substrate,
wherein a two-dimensional diffraction grating is formed in a bonding interface region between the attachment layer and at least one of the main surface of the semiconductor layer, the main surface opposing the attachment layer, and the main surface of the supporting substrate, the main surface opposing the attachment layer, the two-dimensional diffraction grating including at least two types of materials having different refractive indices and being arranged periodically.

2. The semiconductor light-emitting device according to Claim 1,
wherein the materials forming the two-dimensional diffraction grating include
a semiconductor material constituting the semiconductor layer and
a filling material that fills a plurality of concave portions periodically formed on the surface of the semiconductor layer.

3. The semiconductor light-emitting device according to Claim 2, wherein the filling material is a transparent material that makes an ohmic contact with the semiconductor material, transmits light emitted by the active layer, and is electrically conductive.

4. The semiconductor light-emitting device according to Claim 3, wherein the transparent material is composed of a material containing at least one selected from the group consisting of an indium oxide-tin oxide mixture, zinc oxide containing aluminum atoms, tin oxide containing fluorine atoms, zinc oxide, zinc selenide, and gallium oxide.

5. The semiconductor light-emitting device according to Claim 2, wherein the filling material is a dielectric film.

6. The semiconductor light-emitting device according to Claim 5, wherein the dielectric film is composed of a material containing at least one selected from the group consisting of silicon oxide, magnesium fluoride, calcium fluoride, barium fluoride, and lithium fluoride.

7. The semiconductor light-emitting device according to any one of Claims 1 to 6, wherein a reflective film composed of a metal material that reflects light emitted by the active layer is included in a region sandwiched between the two-dimensional diffraction grating and the supporting substrate.

8. The semiconductor light-emitting device according to Claim 7, wherein the reflective film is composed of a material containing at least one selected from the group consisting of aluminum, gold, platinum, silver, copper, and chromium.

9. The semiconductor light-emitting device according to Claim 2, wherein the filling material is air.

10. The semiconductor light-emitting device according to any one of Claims 1 to 9, wherein the supporting substrate is an electrically conductive supporting substrate.

11. The semiconductor light-emitting device according to Claim 10, wherein the electrically conductive supporting substrate is composed of a composed of a material containing at least one selected from the group consisting of silicon, gallium arsenide, and silicon carbide.

12. The semiconductor light-emitting device according to Claim 2, wherein the filling material is a transparent adhesive material that has adhesiveness to the semiconductor layer and the supporting substrate and transmits light emitted by the active layer.

13. The semiconductor light-emitting device according to Claim 12, wherein the transparent adhesive material is composed of a material containing at least one selected from the group consisting of polyimide, epoxy, silicone, and perfluorocyclobutane.

14. The semiconductor light-emitting device according to Claim 12 or 13, wherein the supporting substrate is composed of a material containing at least one selected from the group consisting of sapphire, gallium phosphide, quartz, and spinel.

15. The semiconductor light-emitting device according to any one of Claims 1 to 14, wherein the composition of the active layer is at least one selected from the group consisting of AlₓGa_{y}In_{(1-x-y)}As, AlₓGa_{y}In_{(1-x-y)}P, AlₓIn_{y}Ga_{(1-x-y)}N, and InₓGa₍₁₋ₓ₎AS_{y}P_{(1-y)}.

16. The semiconductor light-emitting device according to any one of Claims 1 to 15, wherein, in the two-dimensional diffraction grating, the two materials having different refractive indices are arranged to form a square lattice.

17. The semiconductor light-emitting device according to any one of Claims 1 to 15, wherein, in the two-dimensional diffraction grating, the two materials having different refractive indices are arranged to form a triangular lattice.

18. The semiconductor light-emitting device according to Claim 16 or 17, wherein the relationship, 0.2λ ≤ a ≤ 10λ, is established where λ represents the wavelength of light emitted by the active layer and a represents the lattice constant of the square or triangular lattice on the main surface of the semiconductor layer.

19. The semiconductor light-emitting device according to Claim 18, wherein the relationship, 0.1λ ≤ d ≤ 5λ, is established where d represents the thickness of the two-dimensional diffraction grating in a direction perpendicular to the main surface of the semiconductor layer.

20. The semiconductor light-emitting device according to any one of Claims 16 to 19, wherein the wavelength λ of the light emitted by the active layer is 400 nm to 2 µm, the lattice constant a is 80 nm to 20 µm, and the thickness d is 40 nm to 10 µm.

21. A method for manufacturing a semiconductor light-emitting device, comprising:
a step of forming a semiconductor layer on a surface of a semiconductor substrate;
a step of preparing a supporting substrate for supporting the semiconductor layer;
a step of forming a two-dimensional diffraction grating on at least one of a surface of the semiconductor layer and a surface of the supporting substrate;
a step of attaching the surface of the semiconductor layer onto the surface of the supporting substrate; and
a step of removing the semiconductor substrate.
